# EUROPEAN PATENT APPLICATION

(11) **EP 4 669 058 A2**
(43) Date of publication of application: **24.12.2025**
(21) Application number: 25214131.2
(22) Date of filing: 31.07.2024
(51) Int. Cl.: H10D 86/40

(54) **DISPLAY APPARATUS**

(30) Priority: 30.08.2023 KR 20230114621
(62) Divisional of application: 24192049.5
(71) Applicant: LG Display Co., Ltd., Seoul, 07336 (KR)
(72) Inventor: Han, Seungjin, 10845 Paju-si (KR); Kwon, Dhang, 10845 Paju-si (KR); Cho, HangSup, 10845 Paju-si (KR); Choi, Moonsun, 10845 Paju-si (KR)
(74) Representative: Morrall, Jonathan Ian McLachlan

(57) **Abstract**

In accordance with an embodiment of the present disclosure, a display apparatus includes a substrate including a display area where an image is displayed; a first thin film transistor disposed on the substrate, and including a first semiconductor layer; and a signal line disposed on the substrate. The display area includes a first area which includes a first transmission area and a second area outside the first area, the signal line includes a first signal line which is disposed in the first area and a second signal line which is disposed in the second area, a part of the first signal line is disposed at the same layer as the first semiconductor layer, and the first signal line includes an oxide semiconductor material.

## Description

### CROSS-REFERENCE TO RELATED APPLICATION

This application claims priority from Korean Patent Application No. 10-2023-0114621 filed on August 30, 2023, which is hereby incorporated by reference for all purposes as if fully set forth herein.

### BACKGROUND

### Field

Embodiments of the present disclosure relate to a display apparatus.

### Description of Related Art

As technology advances, a display apparatus may provide a photographing function and various detection functions in addition to an image display function. To this end, the display apparatus should include an optical device (or a light reception device or a sensor) such as a camera and a detection sensor.

Since the optical device should receive light on the front surface of the display apparatus, the optical device may be disposed at a location where the optical device can receive light. Therefore, in the existing display apparatus, the camera (or a camera lens) and the detection sensor cannot help but be exposed on the front surface. Accordingly, the size of the bezel of the display apparatus may increase or the design of the display apparatus may be subject to significant restrictions.

### BRIEF SUMMARY

Various embodiments of the present disclosure are directed to providing a display apparatus having a light transmission structure in which an optical device may normally receive light (e.g., visible light, infrared light or ultraviolet light) without the optical device being exposed on a front surface.

Various embodiments of the present disclosure are directed to providing a display apparatus which is able to reduce an interconnection deviation between an area where light can transmit and an area where light cannot transmit.

Various embodiments of the present disclosure are directed to providing a display apparatus which has a structure with high transmittance in an area where light can transmit.

Various embodiments of the present disclosure are directed to providing a display apparatus having a structure in which interconnection processes of an area where light can transmit and an area where light cannot transmit are optimized.

A display apparatus in accordance with an embodiment of the present disclosure may include a substrate including a display area where an image is displayed; a first thin film transistor disposed on the substrate, and including a first semiconductor layer; and a signal line disposed on the substrate.

The display area may include a first area which includes a first transmission area and a second area outside the first area.

A display apparatus in accordance with an embodiment of the present disclosure may include a substrate including a display area where an image is displayed; a first thin film transistor disposed on the substrate, and including a first semiconductor layer; and a signal line disposed on the substrate, wherein the display area includes a first area which includes a first transmission area and a second area outside the first area, wherein the signal line includes a first signal line which is disposed in the first area and a second signal line which is disposed in the second area, wherein a part of the first signal line is disposed at the same layer as the first semiconductor layer, and wherein the first signal line includes an oxide semiconductor material. The oxide semiconductor material may include transparent oxide semiconductor material.

According to the embodiments of the present disclosure, it is possible to provide a display apparatus having a light transmission structure in which an optical device may normally receive light (e.g., visible light, infrared light or ultraviolet light) without the optical device being exposed on a front surface.

According to the embodiments of the present disclosure, it is possible to provide a display apparatus which is able to reduce an interconnection deviation between an optical area where light can transmit and an area where light cannot transmit. Accordingly, display driving is made possible, and the image quality of a display panel may be improved. In addition, since a driving method to reduce an interconnection deviation is unnecessary, high-efficiency driving may be possible, and thus, low-power consumption design may also be possible.

According to the embodiments of the present disclosure, it is possible to provide a display apparatus which has improved transmittance in an area where light can transmit. Accordingly, since the light transmission characteristics are made uniform, the operational performance (e.g., camera performance or detection performance) of the optical device may be improved.

According to the embodiments of the present disclosure, by providing a structure in which interconnection processes of an area where light can transmit and an area where light cannot transmit are optimized, it is possible to realize an efficiency process.

It should be noted that effects of the present disclosure are not limited to those described above and other effects of the present disclosure will be apparent to those skilled in the art from the following descriptions.

### DESCRIPTION OF DRAWINGS

FIG. 1 is of views illustrating a display apparatus in accordance with an embodiment of the present disclosure.
FIG. 2 is of views illustrating a display apparatus in accordance with another embodiment of the present disclosure.
FIG. 3 is of views illustrating a display apparatus in accordance with still another embodiment of the present disclosure.
FIG. 4 is a system configuration diagram of a display apparatus in accordance with embodiments of the present disclosure.
FIG. 5 is a view illustrating signal lines which are disposed in a display panel in accordance with the embodiments of the present disclosure.
FIG. 6 is a plan view of an area A illustrated in FIG. 2 in the display panel in accordance with the embodiments of the present disclosure.
FIG. 7 is a plan view of an area B illustrated in FIG. 2 in the display panel in accordance with the embodiments of the present disclosure.
FIG. 8 is a plan view of an area C illustrated in FIG. 2 in the display panel in accordance with the embodiments of the present disclosure.
FIG. 9 is a cross-sectional view of a display panel in accordance with an embodiment of the present disclosure.
FIG. 10 is an enlarged view of an area D illustrated in FIG. 9 in the display panel in accordance with the embodiment of the present disclosure.
FIG. 11 is a plan view of the display panel in accordance with the embodiment of the present disclosure.
FIG. 12 is a cross-sectional view of a display panel in accordance with another embodiment of the present disclosure.
FIG. 13 is a plan view of the display panel in accordance with the other embodiment of the present disclosure.
FIG. 14 is a cross-sectional view of a display panel in accordance with another embodiment of the present disclosure.
FIG. 15 is a plan view of the display panel in accordance with the other embodiment of the present disclosure.

### DETAILED DESCRIPTION

In the following description of examples or embodiments of the present disclosure, reference will be made to the accompanying drawings in which specific examples or embodiments that can be implemented are shown by way of illustration, and in which the same reference numerals and signs can be used to designate the same or like components even when they are shown in different accompanying drawings from one another. Further, in the following description of examples or embodiments of the present disclosure, detailed descriptions of well-known functions and components incorporated herein will be omitted when it is determined that the descriptions may make the subject matter in some embodiments of the present disclosure rather unclear. The terms such as "including," "having," "containing," "constituting," "make up of" and "formed of" used herein are generally intended to allow other components to be added unless the terms are used with the term "only". As used herein, singular forms are intended to include plural forms unless the context clearly indicates otherwise.

Terms, such as "first," "second," "A, " "B," "(A)" and "(B)" may be used herein to describe elements of the present disclosure. Each of these terms is not used to define essence, order, sequence, number of elements, etc., but is used merely to distinguish a corresponding element from other elements.

When it is mentioned that a first element "is connected or coupled to," "contacts or overlaps," etc. a second element, it should be interpreted that not only can the first element "be directly connected or coupled to" or "directly contact or overlap" the second element, but a third element can also be "interposed" between the first and second elements or the first and second elements can "be connected or coupled to," "contact or overlap," etc. each other via a fourth element. Here, the second element may be included in at least one of two or more elements that "are connected or coupled to," "contact or overlap," etc. each other.

When time relative terms, such as "after," "subsequent to," "next," "before" and the like, are used to describe processes or operations of elements or configurations or flows or steps in operating, processing and manufacturing methods, these terms may be used to describe non-consecutive or non-sequential processes or operations unless the term "directly" or "immediately" is used together.

In the case where a numerical value for a component or its corresponding information (e.g., a level, etc.) is mentioned, even though there is no separate explicit description, the numerical value or its corresponding information can be interpreted as including an error range that may be caused by various factors (for example, a process variable, an internal or external shock, noise, etc.).

Hereinafter, various embodiments of the present disclosure will be described in detail with reference to the accompanying drawings.

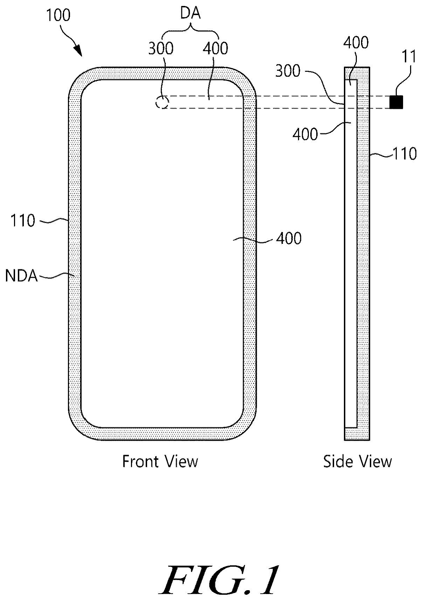

FIG. 1 is of views illustrating a display apparatus in accordance with an embodiment of the present disclosure.

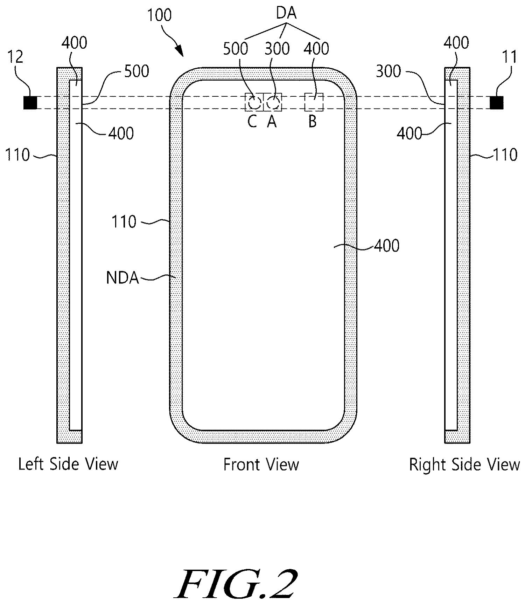

FIG. 2 is of views illustrating a display apparatus in accordance with another embodiment of the present disclosure.

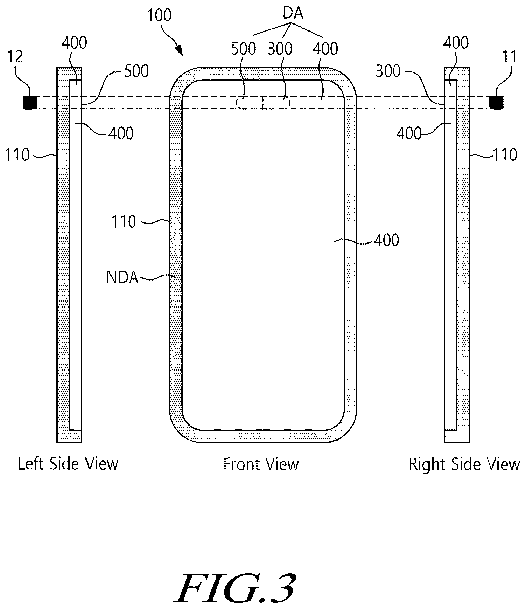

FIG. 3 is of views illustrating a display apparatus in accordance with still another embodiment of the present disclosure.

Referring to FIGS. 1, 2 and 3, a display apparatus 100 in accordance with the embodiments of the present disclosure may include a display panel 110 which displays an image and one or more optical devices 11 and 12.

The display panel 110 may include a display area DA in which an image is displayed and a non-display area NDA in which an image is not displayed.

In the display area DA, subpixels may be disposed, and various signal lines for driving the subpixels may be disposed.

The non-display area NDA may be an area outside the display area DA. In the non-display area NDA, various interconnections may be disposed, and various driving circuits may be connected. The non-display area NDA may be bent to be invisible on a front surface or may be covered by a case. The non-display area NDA may be a bezel or a bezel area.

In the display apparatus 100 in accordance with the embodiments of the present disclosure, the one or more optical devices 11 and 12 may be electronic parts which are provided and installed separately from the display panel 110 and are located under the display panel 110 (on a surface opposite to the viewing surface of the display panel 110).

In the display apparatus 100 in accordance with the embodiments of the present disclosure, the one or more optical devices 11 and 12 may be devices which may perform operations using received light.

The one or more optical devices 11 and 12 may be devices which receive light transmitted through the display panel 110 to perform predetermined operations according to the received light. For example, the one or more optical devices 11 and 12 may include one or more of a photographing device such as a camera (or an image sensor) and a detection sensor such as a proximity sensor and an illuminance sensor. For example, the detection sensor may be an infrared sensor.

Light required for the operations of the one or more optical devices 11 and 12 may enter the front surface (or the viewing surface) of the display panel 110, may transmit through the display panel 110, and may be transferred to the one or more optical devices 11 and 12 which are located under the display panel 110 (or on the surface opposite to the viewing surface of the display panel 110). For example, light required for the operations of the one or more optical devices 11 and 12 and transmitting through the display panel 110 may include at least one of visible light, infrared light and ultraviolet light.

Referring to FIGS. 1, 2 and 3, in the display panel 110 in accordance with the embodiment of the present disclosure, the display area DA may include a first area 300 and a second area 400. The first area 300 may be an optical area, etc. and the second area 400 may be a normal area, etc., but are not limited thereto. An optical area may include the first area 300 or a third area 500. The third area 500 may be an optical area, etc., but is not limited thereto. The first area 300 and the third area 500 may be one or more optical areas 300 and 500, and the one or more optical areas 300 and 500 may be areas which overlap the one or more optical devices 11 and 12.

Referring to FIG. 1, the display area DA may include the first area 300 and the second area 400. At least a part of the first area 300 may overlap the first optical device 11.

Referring to FIG. 2, the display area DA may include the first area 300, the second area 400 and the third area 500. The second area 400 may exist between the first area 300 and the third area 500. At least a part of the first area 300 may overlap the first optical device 11, and at least a part of the third area 500 may overlap the second optical device 12.

Referring to FIG. 3, the display area DA may include the first area 300, the second area 400 and the third area 500. The second area 400 may not exist between the first area 300 and the third area 500. For example, the first area 300 and the third area 500 may contact each other. At least a part of the first area 300 may overlap the first optical device 11, and at least a part of the third area 500 may overlap the second optical device 12.

Each of the one or more optical areas 300 and 500 may be formed with both an image display structure and a light transmission structure. For example, since the one or more optical areas 300 and 500 are parts of the display area DA, the one or more optical areas 300 and 500 may include light emitting areas where subpixels for displaying an image are disposed. The light transmission structure may be formed in each of the one or more optical areas 300 and 500 to transmit light to each of the one or more optical devices 11 and 12.

The one or more optical devices 11 and 12 may be located behind (or under or on the surface opposite to the viewing surface of) the display panel 110 to receive light transmitted through the display panel 110.

The one or more optical devices 11 and 12 may not be exposed on the front surface (or the viewing surface) of the display panel 110. When a user looks at the front surface of the display apparatus 100, the optical devices 11 and 12 may not be visible to the user.

For example, the first optical device 11 may be a camera which receives light (e.g., visible light) of a visible light wavelength band, and the second optical device 12 may be a detection sensor such as a proximity sensor and an illuminance sensor. For example, the detection sensor may be an infrared sensor which detects light (or infrared light) of an infrared wavelength band. Alternatively, the first optical device 11 may be a detection sensor, and the second optical device 12 may be a camera.

Hereunder, for the sake of convenience in explanation, it will be described as an example that the first optical device 11 is a camera and the second optical device 12 is an infrared-based detection sensor. The camera may be a camera lens or an image sensor.

In the case where the first optical device 11 is a camera, the camera may be a front camera which is located on the back of (under) the display panel 110 but photographs the front direction of the display panel 110. Accordingly, the user may perform photographing (or self photographing) through the camera which is not visible on the viewing surface, while looking at the viewing surface of the display panel 110.

The first area 300, the second area 400 and third area 500 included in the display area DA may be areas capable of displaying an image. The second area 400 may be an area which is not formed with a light transmission structure, and each of the first and third areas 300 and 500 may be an area which is formed with a light transmission structure.

The first area 300 or the third area 500 should have transmittance equal to or higher than a predetermined level, and the second area 400 may not have light transmittance or may have low transmittance lower than the predetermined level.

The first area 300, the second area 400 and the third area 500 may be different from one another in terms of resolution, subpixel disposition structure, number of subpixels per unit area, electrode structure, line structure, electrode disposition structure, line disposition structure, etc.

The number of subpixels per unit area in the first area 300 or the third area 500 may be less than the number of subpixels per unit area in the second area 400. The resolution of the first area 300 or the third area 500 may be lower than the resolution of the second area 400. For example, the number of subpixels per unit area may be the same as resolution, pixel density or degree of pixel integration. For example, the unit of the number of subpixels per unit area may be PPI (pixels per inch) that means the number of pixels in 1 inch.

The number of subpixels per unit area in the first area 300 may be less than the number of subpixels per unit area in the second area 400. The number of subpixels per unit area in the third area 500 may be equal to or greater than the number of subpixels per unit area in the first area 300, and may be less than the number of subpixels per unit area in the second area 400.

As a method for increasing the transmittance of at least one of the first area 300 and the third area 500, a differential pixel density design method as described above may be applied. According to the differential pixel density design method, the display panel 110 may be designed such that the number of subpixels per unit area in at least one of the first area 300 and the third area 500 is less than the number of subpixels per unit area in the second area 400.

For another example, as another method for increasing the transmittance of at least one of the first area 300 and the third area 500, a differential pixel size design method may be applied. According to the differential pixel size design method, the display panel 110 may be designed such that the number of subpixels per unit area in at least one of the first area 300 and the third area 500 is the same as or similar to the number of subpixels per unit area in the second area 400 and the size of each subpixel (e.g., the size of a light emitting area) disposed in at least one of the first area 300 and the third area 500 is smaller than the size of each subpixel (e.g., the size of a light emitting area) disposed in the second area 400.

Hereunder, for the sake of convenience in explanation, description will be made on the assumption that, between the two methods for increasing the transmittance of at least one of the first area 300 and the third area 500, for example, the differential pixel density design method and the differential pixel size design method, the differential pixel density design method is applied. Accordingly, in the following description, a small number of subpixels per unit area may mean that the size of each subpixel is small, and a large number of subpixels per unit area may mean that the size of each subpixel is large.

The first area 300 may have various shapes such as circular, oval, quadrangular, hexagonal and octagonal shapes. The third area 500 may have various shapes such as circular, oval, quadrangular, hexagonal and octagonal shapes. The first area 300 and the third area 500 may have the same shape or different shapes.

Referring to FIG. 3, when the first area 300 and the third area 500 contact each other, the entire optical area including the first area 300 and the third area 500 may have various shapes such as circular, oval, quadrangular, hexagonal and octagonal shapes. Hereunder, for the sake of convenience in explanation, it will be described as an example that each of the first area 300 and the third area 500 has a circular shape. The shapes of the first area 300 and the third area 500 do not limit the content of the present disclosure.

In the display apparatus 100 in accordance with the embodiments of the present disclosure, when the first optical device 11 which is not exposed to the outside and is hidden under the display panel 110 is a camera, the display apparatus 100 may be a UDC ( under display camera), but is not limited to the term.

In the display apparatus 100 in accordance with the embodiments of the present disclosure, since a notch or a camera hole for exposing the camera does not need to be formed in the display panel 110, the area of the display area DA is not reduced. Accordingly, since the notch or the camera hole for exposing the camera does not need to be formed in the display panel 110, the size of the bezel area may be reduced, and the degree of freedom in design may be increased. A part of the optical devices 11 and 12 may be formed in the display panel 110 to overlap a notch or a hole for exposing the optical devices 11 and 12. Accordingly, the display apparatus 100 may include both a notch or a hole and the one or more optical areas 300 and 500.

In the display apparatus 100 in accordance with the embodiments of the present disclosure, even though the one or more optical devices 11 and 12 are located by being hidden behind the display panel 110, the one or more optical devices 11 and 12 should be able to normally perform a desired function by normally receiving light.

Furthermore, in the display apparatus 100 in accordance with the embodiments of the present disclosure, even though the one or more optical devices 11 and 12 are located by being hidden behind the display panel 110 and are located to overlap the display area DA, the normal display of an image should be possible in the one or more optical areas 300 and 500 that overlap the one or more optical devices 11 and 12 in the display area DA.

Since the first area 300 is an area which is able to transmit light, display characteristics in the first area 300 may be different from display characteristics in the second area 400.

When the first area 300 is designed to improve display characteristics, the transmittance of the first area 300 may decrease.

Therefore, the embodiments of the present disclosure may provide the structure of the first area 300 which can improve transmittance in the first area 300 without causing a deviation in image quality between the first area 300 and the second area 400.

Even for the third area 500 in addition to the first area 300, the embodiments of the present disclosure may provide the structure of the third area 500 which can improve transmittance in the third area 500 while improving image quality in the third area 500.

Therefore, in the display apparatus 100 in accordance with the embodiments of the present disclosure, although the structure of the first area 300 and the structure of the third area 500 are basically similar or the same, the structure of the first area 300 and the structure of the third area 500 may be different from each other in terms of resolution, subpixel disposition structure, number of subpixels per unit area, electrode structure, line structure, electrode disposition structure, etc.

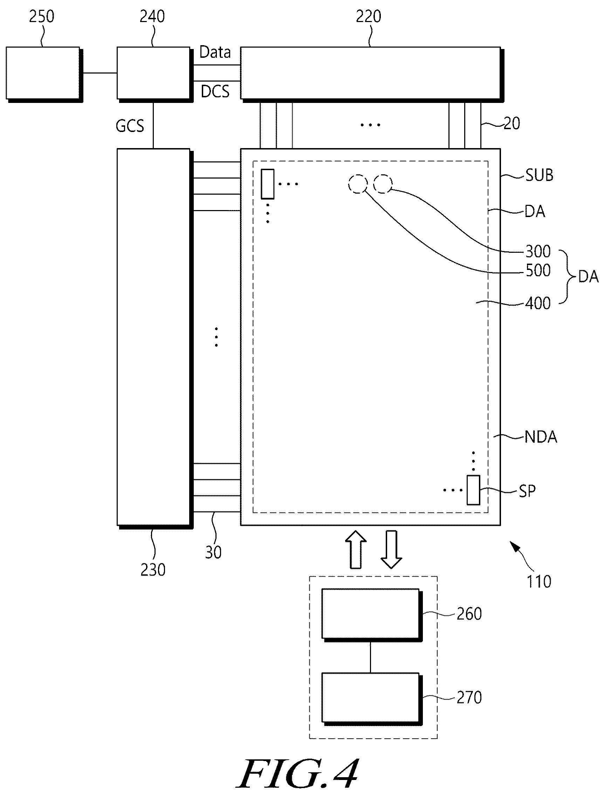

FIG. 4 is a system configuration diagram of a display apparatus in accordance with embodiments of the present disclosure.

Referring to FIG. 4, the display apparatus may include a display panel 110 and a display driving circuit as components for displaying an image. The display driving circuit may be a circuit for driving the display panel 110. The display driving circuit may include a data driving circuit 220, a gate driving circuit 230 and a display controller 240, but the embodiments of the present disclosure are not limited thereto.

The display panel 110 may include a display area DA in which an image is displayed and a non-display area NDA in which an image is not displayed. The non-display area NDA may be an area outside the display area DA, and may also be referred to as a bezel area. The entirety or a part of the non-display area NDA may be an area which is visible on the front surface of the display apparatus or an area which is bent and is not visible on the front surface of the display apparatus.

The display panel 110 may include a substrate SUB and subpixels SP which are disposed on the substrate SUB. In order to drive the subpixels SP, the display panel 110 may further include various types of signal lines.

The display apparatus in accordance with the embodiments of the present disclosure may be a liquid crystal display apparatus or the like, or may be a self-emissive display apparatus in which the display panel 110 self-emits light. When the display apparatus in accordance with the embodiments of the present disclosure is a self-emissive display apparatus, each of the subpixels SP may include a light emitting element. For example, the display apparatus in accordance with the embodiments of the present disclosure may be an organic light emitting display apparatus in which a light emitting element is implemented using an organic light emitting diode (OLED). For another example, the display apparatus in accordance with the embodiments of the present disclosure may be an inorganic light emitting display apparatus in which a light emitting element is implemented using an inorganic-based light emitting diode. For still another example, the display apparatus in accordance with the embodiments of the present disclosure may be a quantum dot display apparatus in which a light emitting element is implemented using quantum dots as semiconductor crystals which self-emit light.

The structure of each of the subpixels SP may vary depending on the type of the display apparatus. For example, when the display apparatus is a self-emissive display apparatus in which each subpixel SP self-emits light, each subpixel SP may include a self-emissive light emitting element, at least one transistor and at least one capacitor.

For example, the various types of signal lines may include data lines 20 which transfer data signals (or data voltages or image signals) and gate lines 30 which transfer gate signals (or scan signals).

The data lines 20 and the gate lines 30 may intersect each other. Each of the data lines 20 may be disposed to extend in a first direction. Each of the gate lines 30 may be disposed to extend in a second direction. The first direction may be a column direction, and the second direction may be a row direction. Alternatively, the first direction may be a row direction, and the second direction may be a column direction. Hereunder, for the sake of convenience in explanation, it will be described as an example that each of the data lines 20 is disposed in a column direction and each of the gate lines 30 is disposed in a row direction. The embodiments of the present disclosure are not limited thereto.

The data driving circuit 220 may be a circuit for driving the data lines 20. The data driving circuit 220 may output data signals to the data lines 20. The gate driving circuit 230 may be a circuit for driving the gate lines 30. The gate driving circuit 230 may output gate signals to the gate lines 30.

The display controller 240 may control the data driving circuit 220 and the gate driving circuit 230. The display controller 240 may control driving timing for the data lines 20 and driving timing for the gate lines 30.

The display controller 240 may supply a data driving control signal DCS to the data driving circuit 220 to control the data driving circuit 220, and may supply a gate driving control signal GCS to the gate driving circuit 230 to control the gate driving circuit 230.

The display controller 240 may receive input image data from a host system 250, and may supply image data Data to the data driving circuit 220 on the basis of the input image data.

The data driving circuit 220 may receive the image data Data of a digital type from the display controller 240, may convert the received image data Data into data signals of an analog type, and may output the data signals to the data lines 20.

The gate driving circuit 230 may be supplied with a first gate voltage corresponding to a turn-on level voltage and a second gate voltage corresponding to a turn-off level voltage along with various gate driving control signals GCS, may generate gate signals, and may supply the generated gate signals to the gate lines 30.

For example, the data driving circuit 220 may be connected to the display panel 110 in a tape automated bonding (TAB) method, may be connected to bonding pads of the display panel 110 in a chip-on-glass (COG) or chip-on-panel (COP) method, or may be connected to the display panel 110 by being implemented in a chip-on-film (COF) method.

The gate driving circuit 230 may be connected to the display panel 110 in a tape automated bonding (TAB) method, may be connected to bonding pads of the display panel 110 in a chip-on-glass (COG) or chip-on-panel (COP) method, or may be connected to the display panel 110 according to a chip-on-film (COF) method. Alternatively, the gate driving circuit 230 may be formed in the non-display area NDA of the display panel 110 in a gate-in-panel (GIP) type. The gate driving circuit 230 may be disposed on the substrate SUB or may be connected to the substrate SUB. For example, in the case of the GIP type, the gate driving circuit 230 may be disposed in the non-display area NDA of the substrate SUB. In the case of the chip-on-glass (COG) type or the chip-on-film (COF) type, the gate driving circuit 230 may be connected to the substrate SUB.

At least one driving circuit of the data driving circuit 220 and the gate driving circuit 230 may be disposed in the display area DA of the display panel 110. For example, at least one driving circuit of the data driving circuit 220 and the gate driving circuit 230 may be disposed not to overlap subpixels SP, or may be disposed to partially or entirely overlap subpixels SP.

The data driving circuit 220 may be connected to one side (e.g., the upper side or the lower side) of the display panel 110. Depending on a driving method, a panel design method, etc., the data driving circuit 220 may be connected to both sides (e.g., the upper side and the lower side) of the display panel 110, or may be connected to at least two sides of the four sides of the display panel 110.

The gate driving circuit 230 may be connected to one side (e.g., the left side or the right side) of the display panel 110. Depending on a driving method, a panel design method, etc., the gate driving circuit 230 may be connected to both sides (e.g., the left side and the right side) of the display panel 110, or may be connected to at least two sides of the four sides of the display panel 110.

The display controller 240 may be implemented as a separate component from the data driving circuit 220. Alternatively, the display controller 240 may be implemented as an integrated circuit by being integrated with the data driving circuit 220.

The display controller 240 may be a timing controller which is used in display technology, may be a control device which includes a timing controller and is capable of further performing other control functions, may be a control device which is different from a timing controller, or may be a circuit in a control device. The display controller 240 may be implemented by various circuits or electronic parts such as an integrated circuit (IC), a field programmable gate array (FPGA), an application specific integrated circuit (ASIC) and a processor.

The display controller 240 may be mounted on a printed circuit board or a flexible printed circuit. The display controller 240 may be electrically connected to the data driving circuit 220 and the gate driving circuit 230 through the printed circuit board or the flexible printed circuit.

The display controller 240 may transmit and receive signals to and from the data driving circuit 220 according to at least one predetermined interface. For example, the interface may include a low voltage differential signaling (LVDS) interface, an EPI (embedded clock point-point interface), a serial peripheral interface (SPI), etc.

In order to further provide a touch sensing function as well as an image display function, the display apparatus in accordance with the embodiments of the present disclosure may include a touch sensor and a touch sensing circuit which, by sensing the touch sensor, detects whether a touch event has occurred by a touch object such as a finger or a pen or detects a touch position.

The touch sensing circuit may include a touch driving circuit 260 which generates and outputs touch sensing data by driving and sensing the touch sensor, and a touch controller 270 which is able to detect the occurrence of a touch event or detect a touch position using the touch sensing data.

The touch sensor may include a plurality of touch electrodes. The touch sensor may further include a plurality of touch lines for electrically connecting the plurality of touch electrodes and the touch driving circuit 260.

The touch sensor may be configured in the form of a touch panel outside the display panel 110, or may be configured inside the display panel 110. In the case where the touch sensor is configured in the form of a touch panel outside the display panel 110, the touch sensor may be referred to as an external type. When the touch sensor is an external type, the touch panel and the display panel 110 may be separately manufactured and be coupled during an assembly process. The external type touch panel may include a substrate for a touch panel and a plurality of touch electrodes on the substrate for a touch panel.

When the touch sensor exists inside the display panel 110, the touch sensor may be formed on the substrate SUB together with signal lines and electrodes related with display driving during the process of manufacturing the display panel 110.

The touch driving circuit 260 may supply a touch driving signal to at least one of the plurality of touch electrodes, and may generate touch sensing data by sensing at least one of the plurality of touch electrodes.

The touch sensing circuit may perform touch sensing in a self-capacitance sensing method or a mutual-capacitance sensing method, but the embodiments of the present disclosure are not limited thereto.

In the case where the touch sensing circuit performs touch sensing in the self-capacitance sensing method, the touch sensing circuit may perform touch sensing on the basis of the capacitance between each touch electrode and a touch object (e.g., a finger, a pen, etc.). According to the self-capacitance sensing method, each of the plurality of touch electrodes may serve as both a driving touch electrode and a sensing touch electrode. The touch driving circuit 260 may drive all or some of the plurality of touch electrodes, and may sense all or some of the plurality of touch electrodes.

In the case where the touch sensing circuit performs touch sensing in the mutual-capacitance sensing method, the touch sensing circuit may perform touch sensing on the basis of the capacitance between touch electrodes. According to the mutual-capacitance sensing method, the plurality of touch electrodes are divided into driving touch electrodes and sensing touch electrodes. The touch driving circuit 260 may drive the driving touch electrodes and sense the sensing touch electrodes.

The touch driving circuit 260 and the touch controller 270 included in the touch sensing circuit may be implemented in separate devices or may be implemented in a single device. Further, the touch driving circuit 260 and the data driving circuit 220 may be implemented in separate devices or may be implemented in a single device.

The display apparatus may further include a power supply circuit which supplies various types of power to the display driving circuit and/or the touch sensing circuit.

The display apparatus in accordance with the embodiments of the present disclosure may be a mobile terminal such as a smart phone and a tablet or a monitor or a television (TV) of various sizes. However, the display apparatus in accordance with the embodiments of the present disclosure is not limited thereto, and may be a display of various types and various sizes capable of displaying information or an image.

In the display panel 110, the display area DA may include a first area 300, a second area 400 and a third area 500. The first area 300, the second area 400 and the third area 500 may be areas capable of displaying an image. The second area 400 may be an area which is not formed with a light transmission structure, and each of the first area 300 and the third area 500 may be an area which is formed with a light transmission structure.

In the display panel 110, the display area DA may include the first area 300 and the third area 500 along with the second area 400. For the sake of convenience in explanation, description will be made on the assumption that the display area DA includes both the first area 300 and the third area 500 (see FIGS. 2 and 3).

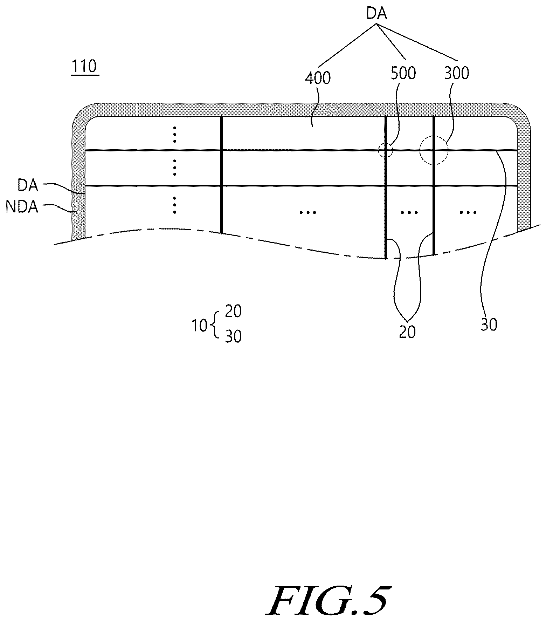

FIG. 5 is a view illustrating signal lines which are disposed in a display panel in accordance with the embodiments of the present disclosure.

Referring to FIG. 5, the display panel 110 in accordance with the embodiments of the present disclosure may include the display area DA in which an image is displayed and the non-display area NDA in which an image is not displayed. The display area DA may include the first area 300, the second area 400 and the third area 500.

For example, each of the first area 300, the second area 400 and the third area 500 may include a plurality of light emitting areas.

The first area 300 and the third area 500 may be areas where light can transmit, and the second area 400 may be an area where light cannot transmit or light transmission is insignificant. The second area 400 may be an area where light cannot transmit and which excludes the first area 300 and the third area 500. Light transmission may mean that light passes through the front and rear surfaces of the display panel 110.

The display panel 110 may include subpixels and signal lines 10 for driving the subpixels.

The signal lines 10 may supply, to the subpixels, various driving signals necessary to drive the subpixels.

For example, the various driving signals may include data signals for driving the data lines 20 and scan signals for driving the gate lines 30. The various driving signals may further include driving voltages for driving driving voltage lines and base voltages for driving base voltage lines connected to a common electrode.

Accordingly, the signal lines 10 may include the data lines 20 for supplying the data signals and the gate lines 30 for supplying gate signals such as the scan signals. The signal lines 10 may further include the driving voltage lines for supplying the driving voltages and the base voltage lines for supplying the base voltages.

The signal lines 10 may be disposed to overlap the first area 300, the second area 400 and the third area 500.

The data lines 20 may be disposed to extend in the first direction. The gate lines 30 may be disposed to extend in the second direction different from the first direction.

The signal lines 10 may include first signal lines which overlap the first area 300 or the third area 500 and second signal lines which overlap the second area 400.

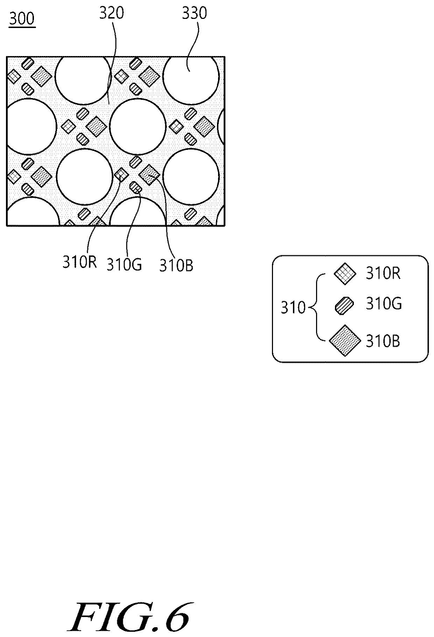

FIG. 6 is a plan view of an area A illustrated in FIG. 2 in the display panel in accordance with the embodiments of the present disclosure.

Referring to FIG. 6, the first area 300 may include a first light emitting area 310, a first non-transmission area 320 and a first transmission area 330.

Each of first transmission areas 330 included in the first area 300 may have various shapes such as circular, oval, polygonal and irregular shapes.

The first transmission areas 330 may have the same shape, or some of the first transmission areas 330 may have a different shape from the others.

The first non-transmission area 320 included in the first area 300 may be an area where no light transmits at all, or may be an area where light transmits with lower transmittance than the first transmission area 330.

The first transmission area 330 may correspond to a location where a plurality of holes are formed in a common electrode. The location where the plurality of holes are formed may be the first area 300.

For example, when first color light is red light, second color light is green light and third color light is blue light, the light emitting area of the first color light may be referred to as a first red light emitting area 310R, the light emitting area of the second color light may be referred to as a first green light emitting area 310G, and the light emitting area of the third color light may be referred to as a first blue light emitting area 310B.

The first red light emitting area 310R, the first green light emitting area 310G and the first blue light emitting area 310B may have the same size (light emitting area size). Alternatively, at least one of the first red light emitting area 310R, the first green light emitting area 310G and the first blue light emitting area 310B may have a size (light emitting area size) that is different from the others.

When a first color is red, a second color is green and a third color is blue, among the size (light emitting area size) of the first red light emitting area 310R, the size (light emitting area size) of the first green light emitting area 310G and the size (light emitting area size) of the first blue light emitting area 310B, the size (light emitting area size) of the first blue light emitting area 310B may be the largest.

A light emitting element which is disposed in the first red light emitting area 310R may include a light emitting layer which emits red light. A light emitting element which is disposed in the first green light emitting area 310G may include a light emitting layer which emits green light. A light emitting element which is disposed in the first blue light emitting area 310B may include a light emitting layer which emits blue light.

Among the light emitting layer which emits red light, the light emitting layer which emits green light and the light emitting layer which emits blue light, the organic material included in the light emitting layer which emits blue light may be most easily degraded. Accordingly, by designing the size of the first blue light emitting area 310B to be the largest, the density of current supplied to the light emitting element disposed in the first blue light emitting area 310B may be the smallest. Therefore, the degradation degree of the light emitting element disposed in the first blue light emitting area 310B may become similar to the degradation degree of the light emitting element disposed in the first red light emitting area 310R and the degradation degree of the light emitting element disposed in the first green light emitting area 310G.

Thus, as deviation in degradation between the light emitting element disposed in the first red light emitting area 310R, the light emitting element disposed in the first green light emitting area 310G and the light emitting element disposed in the first blue light emitting area 310B is eliminated or reduced, the image quality of the display panel 110 may be improved.

The first light emitting area 310 in the first area 300 may include the first red light emitting area 310R, the first green light emitting area 310G and the first blue light emitting area 310B.

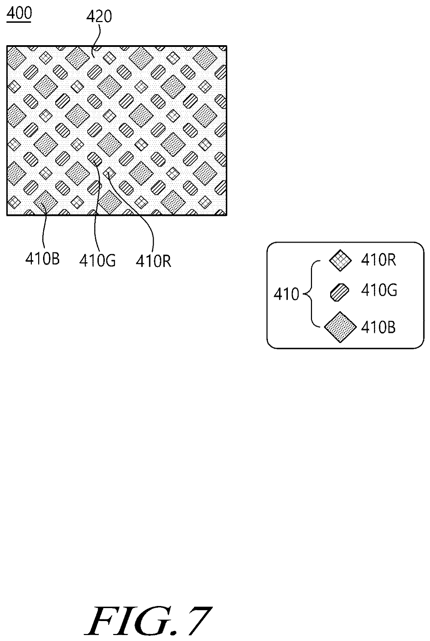

FIG. 7 is a plan view of an area B illustrated in FIG. 2 in the display panel in accordance with the embodiments of the present disclosure.

Referring to FIG. 7, the second area 400 may include a second light emitting area 410 and a second non-transmission area 420.

The second light emitting area 410 may include light emitting areas which emit light of at least three colors. For example, the second light emitting area 410 may include a first color light emitting area which emits first color light, a second color light emitting area which emits second color light, and a third color light emitting area which emits third color light.

A second red light emitting area 410R, a second green light emitting area 410G and a second blue light emitting area 410B may have the same size (light emitting area size). For another example, at least one of the second red light emitting area 410R, the second green light emitting area 410G and the second blue light emitting area 410B may have a size (light emitting area size) that is different from the others.

A first color, a second color and a third color may be different colors and may be various colors. For example, the first color, the second color and the third color may include red, green and blue, respectively. Hereunder, for the sake of convenience in explanation, it will be described as an example that the first color is red, the second color is green and the third color is blue. However, the embodiments of the present disclosure are not limited thereto.

The entirety of the second area 400 may correspond to a non-transmission area. For example, the second area 400 may include the second non-transmission area 420 in which the second light emitting area 410 is included. The entirety of the second area 400 may be the second non-transmission area 420, and the second area 400 may not include a transmission area.

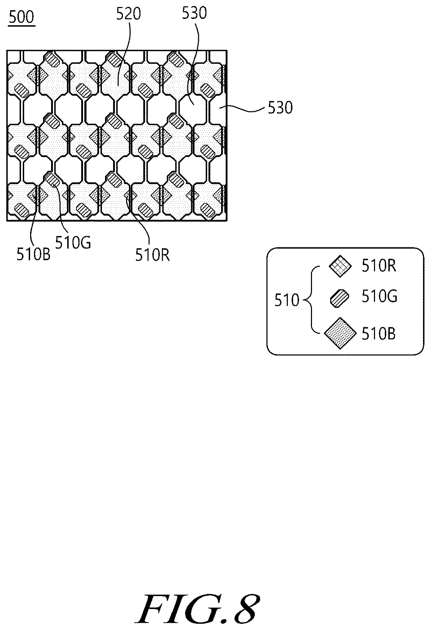

FIG. 8 is a plan view of an area C illustrated in FIG. 2 in the display panel in accordance with the embodiments of the present disclosure.

Referring to FIG. 8, the third area 500 may include a third light emitting area 510, a third non-transmission area 520 and a second transmission area 530.

Each of second transmission areas 530 included in the third area 500 may have various shapes such as circular, oval, polygonal and irregular shapes.

The second transmission areas 530 may have the same shape. Alternatively, some of the second transmission areas 530 may have a shape different from the others.

The third non-transmission area 520 included in the third area 500 may be an area where no light transmits at all, or may be an area where light transmits with lower transmittance than the second transmission area 530.

The second transmission area 530 may correspond to a location where a plurality of holes are formed in a common electrode. For example, the location where the plurality of holes are formed may be the third area 500.

The third light emitting area 510 in the third area 500 may include a third red light emitting area 510R, a third green light emitting area 510G and a third blue light emitting area 510B.

The third light emitting area 510 may have a different subpixel structure from the first light emitting area 310 illustrated in FIG. 6, but is not limited thereto.

The subpixel structures illustrated in FIGS. 7 and 8 may be configured in various ways to minimize the differences in resolution between the second area 400 and the first and third areas 300 and 500, caused due to the presence of the transmission areas 330 and 530 in the first and third areas 300 and 500, and to maximize the performance of the optical devices 11 and 12 disposed to overlap the first and third areas 300 and 500.

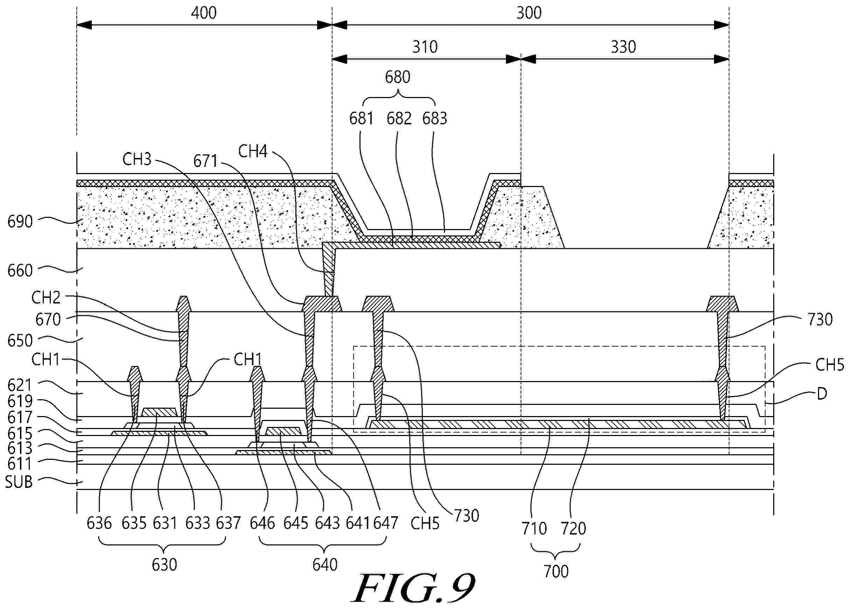

FIG. 9 is a cross-sectional view of a display panel in accordance with an embodiment of the present disclosure.

Referring to FIG. 9, the display panel may include a first area 300 and a second area 400. In FIG. 9, an optical area is illustrated as the first area 300, but it is not limited thereto. For example, the first area 300 may be the third area 500 as illustrated in FIGS. 2 and 3.

Various optical devices such as a camera and an infrared sensor may be disposed in a location overlapping the first area 300.

The second area 400 may include a first thin film transistor 630 and a second thin film transistor 640.

The first thin film transistor 630 may include a first blocking layer 631, a first semiconductor layer 633, a first gate electrode 635, a first source electrode 636 and a first drain electrode 637.

The second thin film transistor 640 may include a second blocking layer 641, a second semiconductor layer 643, a second gate electrode 645, a second source electrode 646 and a second drain electrode 647.

The first thin film transistor 630 may be used as a switching transistor and the second thin film transistor 640 may be used as a driving transistor, but are not limited thereto.

Referring to FIGS. 2 and 9, the display panel may include a substrate SUB. The substrate SUB may include a display area DA and a non-display area NDA around the display area DA. The substrate SUB may support and protect components of a display apparatus which are disposed on the substrate SUB. The substrate SUB may be made of glass or a material with flexibility such as polyimide, but the embodiment of the present disclosure is not limited thereto. There may be a plurality of substrates SUB. An insulating layer may be formed between the plurality of substrates SUB.

A first insulating layer 611 may be formed on the substrate SUB to protect the various components of the display apparatus from penetration of moisture and hydrogen from the outside of the substrate SUB. The first insulating layer 611 may improve the adhesion force between layers formed on the first insulating layer 611 and the substrate SUB, and may block various types of impurities such as an alkaline constituent leaking from the substrate SUB. The first insulating layer 611 may prevent or delay the diffusion of moisture or oxygen that has penetrated the substrate SUB. The first insulating layer 611 may be a buffer layer, etc., but the embodiment of the present disclosure is not limited thereto.

The first insulating layer 611 may be formed of silicon oxide (SiOx), silicon nitride (SiNx) or silicon oxynitride (SiNxOx), but the embodiment of the present disclosure is not limited thereto.

The second blocking layer 641 may be formed on the first insulating layer 611. The second blocking layer 641 may block light so that the semiconductor layer of the second thin film transistor 640 is not damaged. In addition, the second blocking layer 641 may minimize damage to a thin film transistor during the process of forming holes in the display apparatus.

The second blocking layer 641 may be formed as a single layer or a multilayer made of any one or alloy of molybdenum (Mo), copper (Cu), titanium (Ti), aluminum (Al), chromium (Cr), gold (Au), nickel (Ni) and tungsten (W), but is not limited thereto.

A second insulating layer 613 may be formed on the second blocking layer 641. The second insulating layer 613 may be made of the same material as the first insulating layer 611, but is not limited thereto. The second insulating layer 613 may be formed over the first area 300 and the second area 400.

The second semiconductor layer 643 may be formed on the second insulating layer 613. The second semiconductor layer 643 may be made of amorphous silicon, polycrystalline silicon having excellent mobility compared to amorphous silicon to achieve low energy consumption and excellent reliability or oxide semiconductor such as ZnO (zinc oxide), IGZO (indium-gallium-zinc oxide) and ITO (indium-tin oxide), but is not limited thereto. When the second semiconductor layer 643 is made of oxide semiconductor, the effect of blocking the leakage current of a thin film transistor is excellent, and thus, it is possible to minimize change in luminance of a subpixel during low-speed driving.

A third insulating layer 615 may be formed on the second semiconductor layer 643. The third insulating layer 615 may be made of the same material as the first insulating layer 611 and/or the second insulating layer 613, but is not limited thereto. The third insulating layer 615 may be a gate insulating layer, but the embodiment of the present disclosure is not limited thereto.

The second gate electrode 645 may be formed on the third insulating layer 615. The second gate electrode 645 may be formed of the same material as the second blocking layer 641, but is not limited thereto.

The first thin film transistor 630 may be disposed on the substrate SUB. The first thin film transistor 630 may be disposed to be spaced apart from the second thin film transistor 640.

The first thin film transistor 630 may include the first blocking layer 631. The first blocking layer 631 may be formed at the same layer as the second gate electrode 645. The first blocking layer 631 may have the same effect and be made of the same material as the second blocking layer 641, but is not limited thereto.

A fourth insulating layer 617 may be formed on the first blocking layer 631.

The fourth insulating layer 617 may be made of the same material as at least one of the first insulating layer 611, the second insulating layer 613 and the third insulating layer 615, but is not limited thereto.

The first semiconductor layer 633 may be formed on the fourth insulating layer 617.

The first semiconductor layer 633 may be formed of oxide semiconductor such as ZnO (zinc oxide), IGZO (indium-gallium-zinc oxide) and ITO (indium-tin oxide), but the embodiment of the present disclosure is not limited thereto. The first semiconductor layer 633 may be formed as a single layer or a plurality of layers of oxide semiconductor, but is not limited thereto.

A fifth insulating layer 619 may be formed on the first semiconductor layer 633. The fifth insulating layer 619 may be made of the same material as at least one of the first insulating layer 611, the second insulating layer 613, the third insulating layer 615 and the fourth insulating layer 617, but is not limited thereto. The fifth insulating layer 619 may be a gate insulating layer, but the embodiment of the present disclosure is not limited thereto.

The first gate electrode 635 may be formed on the fifth insulating layer 619.

The first gate electrode 635 may be made of the same material as at least one of the first blocking layer 631, the second blocking layer 641 and the second gate electrode 645, but is not limited thereto.

A sixth insulating layer 621 may be formed on the first gate electrode 635.

The sixth insulating layer 621 may be made of the same material as at least one of the first insulating layer 611, the second insulating layer 613, the third insulating layer 615, the fourth insulating layer 617 and the fifth insulating layer 619, but is not limited thereto.

On the sixth insulating layer 621, the first source electrode 636 and the first drain electrode 637 included in the first thin film transistor 630 and the second source electrode 646 and the second drain electrode 647 included in the second thin film transistor 640 may be formed. For example, the first source electrode 636 and the first drain electrode 637 may be formed at the same layer as the second source electrode 646 and the second drain electrode 647.

The first source electrode 636, the first drain electrode 637, the second source electrode 646 and the second drain electrode 647 may be a single layer or a plurality of layers made of any one or alloy of molybdenum (Mo), aluminum (Al), chromium (Cr), gold (Au), titanium (Ti), nickel (Ni), neodymium (Nd) and copper (Cu), but is not limited thereto. For example, the first source electrode 636 and the first drain electrode 637 may be formed as a triple layer of Ti/Al/Ti, but are not limited thereto.

The first source electrode 636 and the first drain electrode 637 may be electrically connected to the first semiconductor layer 633 through first contact holes CH1 which are formed in the fifth insulating layer 619 and the sixth insulating layer 621.

A first protective layer 650 may be formed on the first source electrode 636, the first drain electrode 637, the second source electrode 647 and the second drain electrode 647.

The first protective layer 650 may be formed of at least one material among organic insulating materials such as acryl resin, epoxy resin, phenolic resin, polyamide resin and polyimide resin, but is not limited thereto.

For example, the first protective layer 650 may be a first planarization layer, but the embodiment of the present disclosure is not limited thereto.

A second protective layer 660 may be formed on the first protective layer 650. The second protective layer 660 may be made of the same material as the first protective layer 650, but is not limited thereto.

For example, the second protective layer 660 may be a second planarization layer, but the embodiment of the present disclosure is not limited thereto.

A first connection electrode 670 may be formed between the first protective layer 650 and the second protective layer 660.

The second connection electrode 671 may electrically connect the second thin film transistor 640 and the light emitting part 680. The second connection electrode 671 may electrically connect the second thin film transistor 640 through a third contact hole CH3 which is formed in the first protective layer 650. The second connection electrode 671 may electrically connect the light emitting part 680 through a fourth contact hole CH4 which is formed in the second protective layer 660.

A second connection electrode 671 may be formed between the first protective layer 650 and the second protective layer 660.

The first connection electrode 670 may be electrically connected to the first thin film transistor 630 through a second contact hole CH2 which is formed in the first protective layer 650.

The first connection electrode 670 and the second connection electrode 671 may be formed of the same material as the first source electrode 636, the first drain electrode 637, the second source electrode 646 and the second drain electrode 647, but is not limited thereto.

The first connection electrode 670 and the second connection electrode 671 may be connection electrodes.

A light emitting part 680 which includes a first electrode 681, a light emitting layer 682 and a second electrode 683 may be formed on the second protective layer 660.

The first electrode 681 may be electrically connected to the second thin film transistor 640 through a fourth contact hole CH4 which is formed in the second protective layer 660.

The first electrode 681 may supply holes to the light emitting layer 682, and may be made of a conductive material which has high work function.

The first electrode 681 may be formed of at least one of silver (Ag), aluminum (Al), gold (Au), molybdenum (Mo), tungsten (W), chromium (Cr), alloy thereof and oxide such as ITO (indium-tin oxide), but is not limited thereto.

The first electrode 681 may be an anode electrode, but the embodiment of the present disclosure is not limited thereto.

The light emitting layer 682 may be formed on the first electrode 681. The light emitting layer 682 may be made of an organic material for emitting light of a specific color. The light emitting layer 682 may be configured with at least one of a red light emitting layer, a green light emitting layer, a blue light emitting layer and/or a white light emitting layer.

The second electrode 683 may be formed on the light emitting layer 682. The second electrode 683 may be made of at least one of oxide such as ITO (indium-tin oxide) and IZO (indium-zinc oxide), silver (Ag), aluminum (Al), gold (Au), molybdenum (Mo), tungsten (W), chromium (Cr) and alloy thereof, but is not limited thereto.

The second electrode 683 may be a cathode electrode, but the embodiment of the present disclosure is not limited thereto.

A bank 690 may be formed on the second protective layer 660. The bank 690 may be formed in an area except a light emitting area. The bank 690 may be made of an inorganic insulating material such as silicon nitride (SiNx) and silicon oxide (SiOx) or an organic insulating material like the first protective layer 650 and the second protective layer 660, but is not limited thereto.

The first area 300 may include a first light emitting area 310 and a first transmission area 330.

The first light emitting area 310 may include the light emitting part 680. Since the first light emitting area 310 includes the light emitting part 680, the first area 300 may emit light like the second area 400.

The first light emitting area 310 and the first transmission area 330 may be formed through an area which is surrounded by the bank 690. For example, the first light emitting area 310 and the first transmission area 330 may be formed through holes.

An area surrounded by the bank 690 may have a circular or oval shape, but is not limited thereto.

The first area 300 may include a first signal line 700. The first signal line 700 may be made of the same material as the first semiconductor layer 633.

For example, the first signal line 700 may include ITO (indium-tin oxide) or IGZO (indium-gallium-zinc oxide ) as the same material as the first semiconductor layer 633, but is limited thereto.

Since the first signal line 700 includes oxide with high transmittance such as ITO (indium-tin oxide) or IGZO (indium-gallium-zinc oxide), the first area 300 may have higher transmittance.

The first signal line 700 may be formed as the same layer as the first semiconductor layer 633.

As the first signal line 700 is formed of the same material and as the same layer as the first semiconductor layer 633, the display apparatus formed through the embodiment of the present disclosure may be formed through an efficient process.

The first signal line 700 may include a first layer line 710 which is disposed in a first layer and a second layer line 720 which is disposed in a second layer. For example, the first signal line 700 may be formed as a multilayer (e.g., a double layer), but is not limited thereto. The first signal line 700 may be formed as a single layer or may be formed as a plurality of layers.

A first line 730 may be formed on the first signal line 700.

The first line 730 may be electrically connected to the first signal line 700 through a fifth contact hole CH5 which is formed in the fifth insulating layer 619, the sixth insulating layer 621 and the first protective layer 650. The first line 730 may be electrically connected to the signal line 10 illustrated in FIG. 5. A second signal line may be disposed in the second area 400. For example, the first line 730 may electrically connect the first signal line 700 in the first area 300 and the second signal line in the second area 400.

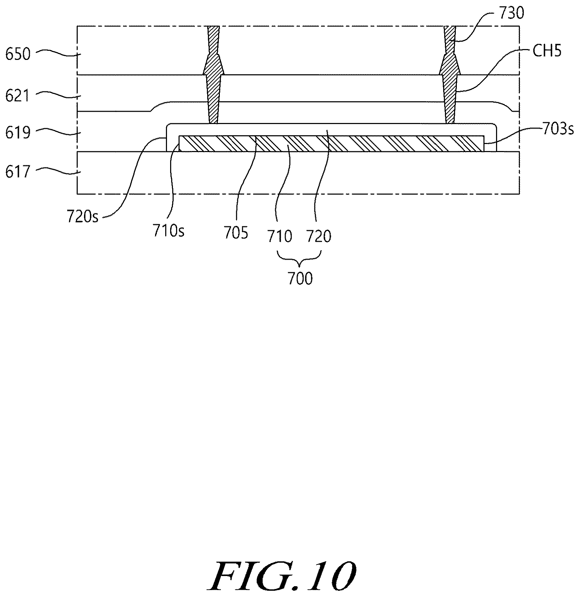

FIG. 10 is an enlarged view of an area D illustrated in FIG. 9 in the display panel in accordance with the embodiment of the present disclosure.

Referring to FIGS. 9 and 10, the first signal line 700 may be formed in the first area 300. Hereinafter, substantially the same components as those in FIG. 9 will be given the same reference numerals, repeated descriptions thereof will be omitted, and components different from FIG. 9 will be described.

The first signal line 700 may be formed at the same layer as the first semiconductor layer 633 which is included in the first thin film transistor 630.

The first signal line 700 may include the first layer line 710 and the second layer line 720 on the first layer line 710. The first layer line 710 may be formed to overlap the second layer line 720.

The first layer line 710 may include a first side surface 710s and a third side surface 703s opposite and facing the first side surface 710s, and the second layer line 720 may include a second side surface 720s. A second surface 705 is between the first side surface 710s and the third side surface 703s. The second side surface 720s of the second layer line 720 may cover the first side surface 710s of the first layer line 710. For example, the first signal line 700 may have a clad structure. For example, the second layer line 720 may cover the first layer line 710. For example, the second layer line 720 may completely cover the first side surface 710s, the second surface 705, and the third side surface 703s of the first layer line 710.

A direction (e.g., the horizontal direction) in which the first side surface 710s of the first layer line 710 and the second side surface 720s of the second layer line 720 are stacked may be perpendicular to a direction (e.g., the vertical direction) in which the first layer line 710 disposed in the first layer and the second layer line 720 disposed in the second layer are stacked.

For example, the second layer line 720 may include an extending portion which extends in the direction opposite to the direction in which the first layer line 710 and the second layer line 720 are stacked. The extending portion may overlap the first side surface 710s.

The first signal line 700 may include oxide semiconductor.

The first signal line 700 may include transparent conductive oxide. For example, transparent conductive oxide may include ITO (indium-tin oxide), IGZO (indium-gallium-zinc oxide), IZO (indium-zinc oxide), ZnO (zinc oxide), AZO (aluminum-doped zinc oxide) or GZO (gallium-doped zinc oxide), but is not limited thereto. Transparent conductive oxide may be an oxide semiconductor material. The oxide semiconductor material may include transparent oxide semiconductor material.

Each of the first layer line 710 and the second layer line 720 included in the first signal line 700 may include transparent conductive oxide.

The transparent conductive oxides of the first layer line 710 and the second layer line 720 included in the first signal line 700 may be the same.

For another example, the transparent conductive oxides of the first layer line 710 and the second layer line 720 may be different from each other. For example, the first layer line 710 may include first transparent conductive oxide, and the second layer line 720 may include second transparent conductive oxide different from the first transparent conductive oxide. For example, the first transparent conductive oxide may include ITO (indium-tin oxide). The second transparent conductive oxide may include IZO (indium-zinc oxide) or IGZO (indium-gallium-zinc oxide).

For example, the first layer line 710 and the second layer line 720 included in the first signal line 700 may be made of different materials.

The first side surface 710s may be made of the same material as the first layer line 710, and the second side surface 720s may be made of the same material as the second layer line 720.

Since the first signal line 700 is formed of oxide semiconductor in the first area 300, the light transmittance of the first area 300 may be increased.

For example, ITO (indium-tin oxide) may have higher transmittance characteristics compared to IGZO (indium-gallium-zinc oxide), and IGZO (indium-gallium-zinc oxide) may have lower resistance characteristics compared to ITO (indium-tin oxide).

The first line 730 may be formed on the first signal line 700. The first signal line 700 may be electrically connected to the first line 730 through the fifth contact hole CH5.

The first line 730 may be electrically connected to the second layer line 720 of the first signal line 700, which includes IGZO (indium-gallium-zinc oxide). As the first line 730 is electrically connected to the second layer line 720 which has lower resistance characteristics, the display apparatus may efficiently transfer an electrical signal.

Referring to FIGS. 9 and 10, since the first area 300 includes the first signal line 700 having the first layer line 710 which includes the first transparent conductive oxide such as ITO (indium-tin oxide) and the second layer line 720 which includes the second transparent conductive oxide such as IGZO (indium-gallium-zinc oxide), the first area 300 may include both higher transmittance characteristics and lower resistance characteristics. However, the embodiment of the present disclosure is not limited thereto.

For example, the first signal line 700 may be configured with a single layer.

When the first signal line 700 is configured with a single layer, the first signal line 700 may include transparent conductive oxide. For example, transparent conductive oxide may include ITO (indium-tin oxide), IZO (indium-zinc oxide), IGZO (indium-gallium-zinc oxide), AZO (aluminum-doped zinc oxide) or GZO (gallium-doped zinc oxide), but is not limited thereto.

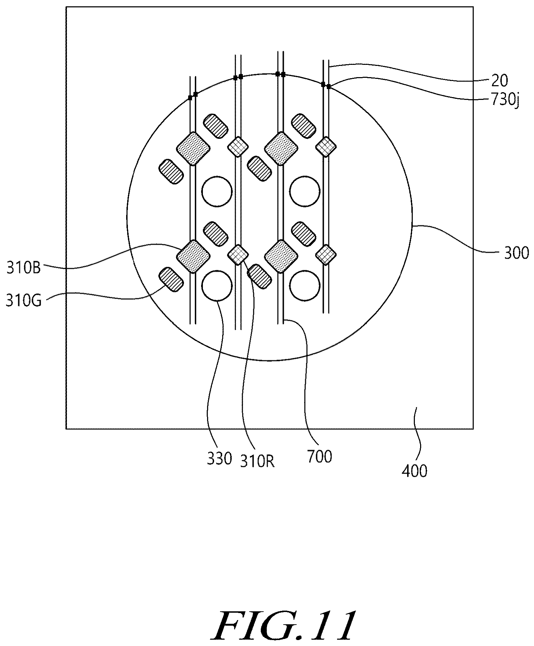

FIG. 11 is a plan view of the display panel in accordance with the embodiment of the present disclosure.

Referring to FIGS. 9 and 11, the display apparatus may include the first area 300 and the second area 400. The first area 300 may include a first red light emitting area 310R, a first green light emitting area 310G and a first blue light emitting area 310B. At least one of the first red light emitting area 310R, the first green light emitting area 310G and the first blue light emitting area 310B may be formed to overlap the first signal line 700.

The first red light emitting area 310R, the first green light emitting area 310G and the first blue light emitting area 310B may have different shapes, respectively, but are not limited thereto. In the embodiment of the present disclosure, it is illustrated that the first red light emitting area 310R, the first green light emitting area 310G and the first blue light emitting area 310B are formed in a ratio of 1:2:1, but are not limited thereto. A pixel structure in the first area 300, the shape of the first transmission area 330, etc. may be changed depending on the one or more optical devices 11 and 12 illustrated in FIGS. 1 to 3 or design characteristics.

The first signal line 700 may be formed as a double interconnection, but is not limited thereto.

The boundary portion of the first area 300 may include a first portion 730j. The first portion 730j may be a portion which is electrically connected to the first signal line 700 and at least one of the signal lines 10 illustrated in FIG. 5.

For example, the first portion 730j may be a portion which electrically connects the data line 20 illustrated in FIG. 5 and the first signal line 700.

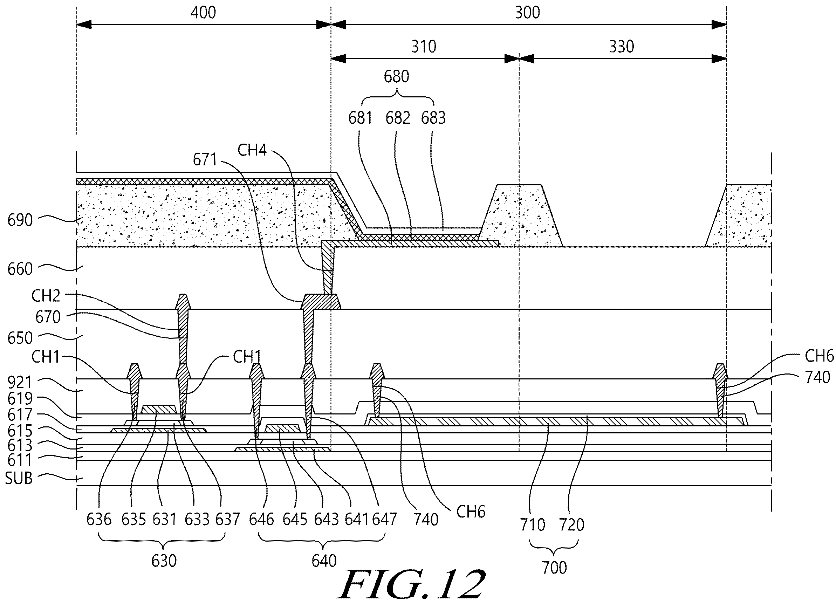

FIG. 12 is a cross-sectional view of a display panel in accordance with another embodiment of the present disclosure.

Hereinafter, in FIGS. 12 to 15, substantially the same components as those in FIGS. 9 to 11 will be given the same reference numerals, repeated descriptions thereof will be omitted, and different components will be mainly described.

Referring to FIG. 12, the first area 300 may include the first signal line 700.

A second line 740 may be formed on the first signal line 700. The second line 740 may be electrically connected to the first signal line 700 through a sixth contact hole CH6.

The second line 740 may be made of the same material and be formed at the same layer as the first source electrode 636, the first drain electrode 637, the second source electrode 646 and the second drain electrode 647.

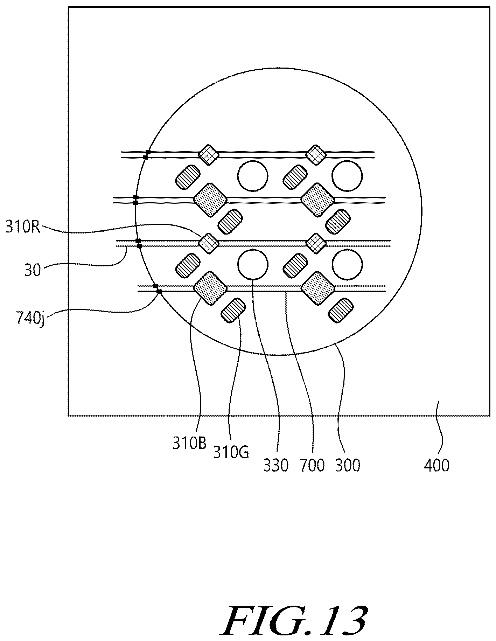

FIG. 13 is a plan view of the display panel in accordance with the other embodiment of the present disclosure.

Referring to FIGS. 12 and 13, the boundary portion of the first area 300 may include a second portion 740j. The second portion 740j may be a portion which is electrically connected to the first signal line 700 and at least one of the signal lines 10 illustrated in FIG. 5.

For example, the second portion 740j may be a portion which electrically connects the gate line 30 illustrated in FIG. 5 and the first signal line 700.

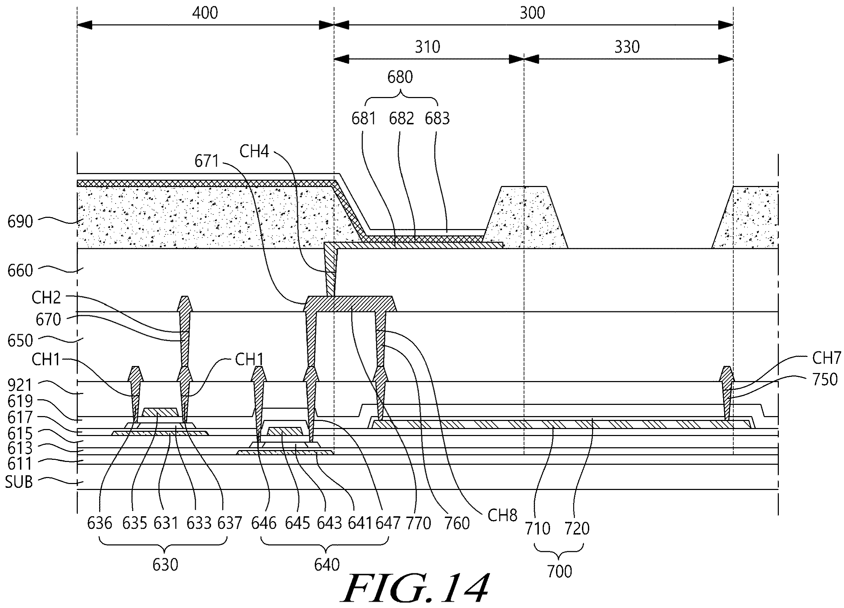

FIG. 14 is a cross-sectional view of a display panel in accordance with another embodiment of the present disclosure.

Referring to FIG. 14, the first area 300 may include a third line 750 and a fourth line 760.

The third line 750 may electrically connect the first signal line 700 and the signal line 10 illustrated in FIG. 5 through a seventh contact hole CH7. The third line 750 may be made of the same material and be formed at the same layer as the first source electrode 636, the first drain electrode 637, the second source electrode 646 and the second drain electrode 647.

The fourth line 760 may electrically connect the first signal line 700 and the signal line 10 illustrated in FIG. 5 through an eighth contact hole CH8. The fourth line 760 may be made of the same material and be formed at the same layer as the first connection electrode 670 or the second connection electrode 671 illustrated in FIGS. 9 and 14.

A third connection electrode 770 may be formed over the second thin film transistor 640.

The third connection electrode 770 may electrically connect the first signal line 700 and the second thin film transistor 640.

The third connection electrode 770 may be connected to the first electrode 681. Accordingly, the first signal line 700 may be connected to the first electrode 681.

The third connection electrode 770 may be made of the same material and be formed at the same layer as the first connection electrode 670. The third connection electrode 770 may be formed over the first area 300 and the second area 400.

Referring to FIG. 14, the first signal line 700 may include the third line 750 and the fourth line 760. The third line 750 and the fourth line 760 may be formed at different layers.

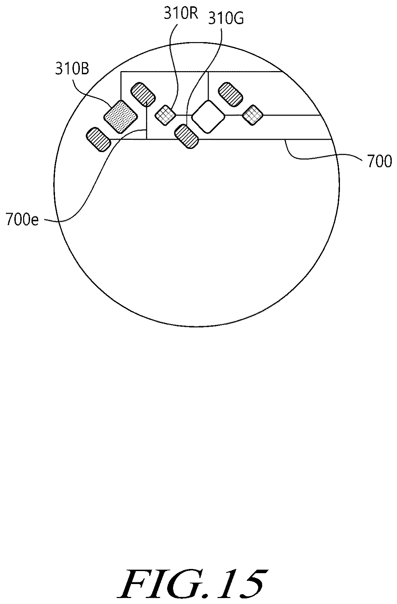

FIG. 15 is a plan view of the display panel in accordance with the other embodiment of the present disclosure.

Referring to FIGS. 14 and 15, the first area 300 may include the first signal line 700, a first red light emitting area 310R, a first green light emitting area 310G and a first blue light emitting area 310B. The first signal line 700 may be formed as a single interconnection. The first signal line 700 may overlap at least one of the first red light emitting area 310R, the first green light emitting area 310G and the first blue light emitting area 310B.

The first signal line 700 may include a first extending line 700e. The first signal line 700 may be formed to extend in a third direction. The first extending line 700e may extend from the first signal line 700, and may be formed in a fourth direction different from the third direction. The first extending line 700e may be formed to overlap at least one of the first red light emitting area 310R, the first green light emitting area 310G and the first blue light emitting area 310B. The first extending line 700e is illustrated in FIG. 15 to overlap the first green light emitting area 310G, but is not limited thereto.

For example, at least one of first signal lines 700 may be connected to a plurality of subpixels which are included in the first light emitting area 310.

The first signal line 700 may include ITO (indium-tin oxide), but is not limited thereto.

A brief description of the embodiments of the present disclosure described above is as follows.

A display apparatus in accordance with an embodiment of the present disclosure may include a substrate including a display area where an image is displayed; a first thin film transistor disposed on the substrate, and including a first semiconductor layer; and a signal line disposed on the substrate, wherein the display area includes a first area which includes a first transmission area and a second area outside the first area, wherein the signal line includes a first signal line which is disposed in the first area and a second signal line which is disposed in the second area, wherein a part of the first signal line is disposed at the same layer as the first semiconductor layer, and wherein the first signal line includes an oxide semiconductor material.

According to at least one embodiment of the present disclosure, the first signal line may include a first layer line and a second layer line. The first layer line and the second layer line may be electrically connected to each other. The first layer line and the second layer line may include different materials.

According to at least one embodiment of the present disclosure, the second layer line may completely cover the first layer line. The second layer line may be located on top of and on side of the first layer line.

According to at least one embodiment of the present disclosure, the first layer line may include a first side surface, and the second layer line may include a second side surface. The second side surface of the second layer line may cover the first side surface of the first layer line.

According to at least one embodiment of the present disclosure, the first layer line may include first transparent conductive oxide. The second layer line may include second transparent conductive oxide different from the first transparent conductive oxide.

According to at least one embodiment of the present disclosure, the first signal line may be configured with a single layer.

According to at least one embodiment of the present disclosure, the first signal line may include transparent conductive oxide.

According to at least one embodiment of the present disclosure, the display apparatus may further include a first protective layer over the first thin film transistor; a second protective layer on the first protective layer; and a connection electrode between the first protective layer and the second protective layer. The display apparatus may further include a first line disposed at the same layer as the connection electrode and disposed in the first area, and the first signal line may be connected to the first line through a contact hole.

According to at least one embodiment of the present disclosure, the first line may be electrically connected to a data line.

According to at least one embodiment of the present disclosure, the first thin film transistor may further include a first source electrode and a first drain electrode on the first semiconductor layer, and the display apparatus may further include a second line disposed at the same layer as the first source electrode and the first drain electrode and disposed in the first area. The first signal line may be connected to the second line through a contact hole.

According to at least one embodiment of the present disclosure, the second line may be electrically connected to a gate line.

According to at least one embodiment of the present disclosure, the display apparatus may further include a second thin film transistor disposed to be spaced apart from the first thin film transistor, and including a second semiconductor layer. The first semiconductor layer and the second semiconductor layer may be made of different materials.

According to at least one embodiment of the present disclosure, the display apparatus may further include a first electrode over the signal line; a light emitting layer on the first electrode; and a second electrode on the light emitting layer. The second electrode may include a hole in the first transmission area.

According to at least one embodiment of the present disclosure, the first area may include a first light emitting area, and the second area may include a second light emitting area. The first light emitting area and the second light emitting area may have different pixel structures.

According to at least one embodiment of the present disclosure, the display apparatus may further include a third area outside the first area. The third area may include a third light emitting area, and the second light emitting area and the third light emitting area may have different pixel structures.

According to at least one embodiment of the present disclosure, the first signal line may be connected to the first electrode.

According to at least one embodiment of the present disclosure, the display apparatus may further include a plurality of subpixels in the first area, and at least one of first signal lines may be connected to the plurality of subpixels.

According to at least one embodiment of the present disclosure, the display apparatus may further include an optical device located under the substrate and overlapping at least a portion of the first area. The optical device may perform a predetermined operation on the basis of light received by transmitting the first area.

For example, light received through the first area for the optical device to perform the predetermined operation may be visible light, infrared light or ultraviolet light. For another example, light may be electromagnetic wave of a wavelength band different from visible light, infrared light and ultraviolet light. For example, the optical device may include at least one among an image sensor (e.g., a camera) which performs image sensing processing on the basis of light received through the first area, a proximity sensor for detecting a surrounding object or the human body and an illuminance sensor for estimating ambient brightness (for example, illuminance).

According to at least one embodiment of the present disclosure, the first signal line may include transparent conductive oxide. The second signal line may not include the transparent conductive oxide.

According to at least one embodiment of the present disclosure, the first signal line may be configured with a multilayer. The second signal line may be configured with a single layer.

The above description has been presented to enable any person skilled in the art to make and use the technical idea of the present disclosure, and has been provided in the context of a particular application and its requirements. Various modifications, additions and substitutions to the described embodiments will be readily apparent to those skilled in the art, and the general principles defined herein may be applied to other embodiments and applications without departing from the spirit and scope of the present disclosure. The above description and the accompanying drawings provide an example of the technical idea of the present disclosure for illustrative purposes only. That is, the disclosed embodiments are intended to illustrate the scope of the technical idea of the present disclosure.

The present disclosure also includes the following numbered clauses:
Clause 1. A display apparatus comprising: a substrate including a display area where an image is displayed; a first thin film transistor disposed on the substrate, and including a first semiconductor layer; and a signal line disposed on the substrate, wherein the display area includes a first area which includes a first transmission area and a second area outside the first area, wherein the signal line includes a first signal line which is disposed in the first area and a second signal line which is disposed in the second area, wherein a part of the first signal line is disposed at the same layer as the first semiconductor layer, and wherein the first signal line includes a oxide semiconductor material.
Clause 2. The display apparatus of clause 1, wherein the first signal line includes a first layer line which is disposed in a first layer and a second layer line which is disposed in a second layer, and the first layer line and the second layer line are electrically connected to each other, and include different materials from each other.
Clause 3. The display apparatus of clause 2, wherein the first layer line includes a first side surface, a third side surface opposite the first side surface, and a second surface between the first side surface and the third side surface, and wherein second layer line completely covers the first side surface, the second surface, and the third side surface of the first layer line; and/or wherein: the first layer line includes a first side surface, the second layer line includes a second side surface, and the second side surface of the second layer line covers the first side surface of the first layer line.
Clause 4. The display apparatus of clause 2, wherein the first layer line includes first transparent conductive oxide, and the second layer line includes second transparent conductive oxide different from the first transparent conductive oxide.
Clause 5. The display apparatus of clause 1, wherein the first signal line is configured with a single layer; and, optionally wherein the first signal line may include a transparent conductive oxide.
Clause 6. The display apparatus of clause 1, further comprising: a first protective layer on the first thin film transistor; a second protective layer on the first protective layer; a connection electrode between the first protective layer and the second protective layer; and a first line disposed at a same layer as the connection electrode and disposed in the first area, wherein the first signal line is electrically connected to the first line through a contact hole.
Clause 7. The display apparatus of clause 6, further comprising: a data line electrically connected to the first line.
Clause 8. The display apparatus of clause 1, wherein the first thin film transistor further includes a first source electrode and a first drain electrode on the first semiconductor layer, the display apparatus further comprises a second line disposed on the same layer as the first source electrode and the first drain electrode and disposed in the first area, and the first signal line is electrically connected to the second line through a contact hole; and wherein the display apparatus may further comprise a gate line electrically connected to the second line.
Clause 9. The display apparatus of clause 1, further comprising:
   a second thin film transistor disposed to be spaced apart from the first thin film transistor, the second thin film transistor including a second semiconductor layer, wherein the first semiconductor layer and the second semiconductor layer are made of different materials.
Clause 10. The display apparatus of clause 1, further comprising: a first electrode on the signal line; a light emitting layer on the first electrode; and a second electrode on the light emitting layer, wherein the second electrode includes a hole in the first transmission area; and, optionally wherein the first signal line is electrically connected to the first electrode.
Clause 11. The display apparatus of clause 1, wherein the first area includes a first light emitting area, the second area includes a second light emitting area, and the first light emitting area and the second light emitting area have different pixel structures; and wherein the display apparatus may further comprise: a third area outside the first area, wherein the third area includes a third light emitting area, and wherein the first light emitting area and the third light emitting area have different pixel structures.
Clause 12. The display apparatus of clause 1, further comprising: a plurality of subpixels in the first area, wherein at least one of first signal lines is electrically connected to the plurality of subpixels.
Clause 13. The display apparatus of clause 1, further comprising: an optical device located under the substrate, and overlapping at least a portion of the first area, wherein the optical device performs a predetermined operation on the basis of light received by transmitting the first area.
Clause 14. The display apparatus of clause 1, wherein the first signal line includes transparent conductive oxide, and the second signal line does not include the transparent conductive oxide.
Clause 15. The display apparatus of clause 1, wherein the first signal line is configured with a multilayer, and the second signal line is configured with a single layer.

## Claims

1. A display apparatus comprising:
a substrate including a display area where an image is displayed, the display area including a first area and a second area outside the first area, the first area including a first transmission area;
a first thin film transistor disposed on the substrate, the first thin film transistor including a first semiconductor layer; and
a transparent signal line disposed on the substrate, the transparent signal line overlapping with the first transmission area and electrically connected to the first semiconductor layer.

2. The display apparatus of claim 1, wherein the first area further comprising a plurality of light emitting areas, the transparent signal line is shared by at least two of the plurality of light emitting areas.

3. The display apparatus of claim 2, wherein either:
the transparent signal line comprising a main line and an extending line, wherein the main line and the extending line are formed to extend in different directions, or
the at least two of the plurality of light emitting areas are green light emitting areas.

4. The display apparatus of any preceding claim, further comprising two insulating layers, disposed on the substrate;
wherein the first semiconductor layer is disposed at one of the two insulating layers,
the first thin film transistor further includes a first connection electrode contacting the first semiconductor layer and extending through the two insulating layers, and
the transparent signal line is disposed between the two insulating layers.

5. The display apparatus of any preceding claim, further comprising a second thin film transistor, wherein the first thin film transistor further includes a first gate electrode and the second thin film transistor includes a second gate electrode,
the transparent signal line is disposed between a layer where the first gate electrode is disposed and a layer where the second gate electrode is disposed.

6. The display apparatus of any preceding claim, further comprising a bank disposed on the substrate;
wherein the first transmission area is formed through an area surrounded by the bank.

7. The display apparatus of claim 6, further comprising a common electrode disposed on the substrate, wherein the first transmission area corresponds to a location where a plurality of holes are formed in the common electrode.

8. The display apparatus of any preceding claim, wherein
the transparent signal line includes a first layer line which is disposed in a first layer and a second layer line which is disposed in a second layer, and
the transparent line and the second layer line are electrically connected to each other, and include different materials from each other.

9. The display apparatus of claim 8, wherein either:
the first layer line includes a first side surface, a third side surface opposite the first side surface, and a second surface between the first side surface and the third side surface, and
wherein the second layer line completely covers the first side surface, the second surface, and the third side surface of the first layer line; or
the first layer line includes a first side surface,
the second layer line includes a second side surface, and
the second side surface of the second layer line covers the first side surface of the first layer line; or
the first layer line includes first transparent conductive oxide, and
the second layer line includes second transparent conductive oxide different from the first transparent conductive oxide.

10. The display apparatus of any preceding claim, wherein the transparent signal line is configured with a single layer.

11. The display apparatus of claim 10, wherein the transparent signal line includes transparent conductive oxide.

12. The display apparatus of any preceding claim, further comprising:
a first protective layer on the first thin film transistor;
a second protective layer on the first protective layer;
a connection electrode between the first protective layer and the second protective layer; and
a first line disposed at a same layer as the connection electrode and disposed in the first area,
wherein the transparent signal line is electrically connected to the first line through a contact hole;
and optionally further comprising a data line electrically connected to the first line.

13. The display apparatus of any preceding claim, wherein
the first thin film transistor further includes a first source electrode and a first drain electrode on the first semiconductor layer, the display apparatus further comprises a second line disposed at a same layer as the first source electrode and the first drain electrode and disposed in the first area, and
the transparent signal line is electrically connected to the second line through a contact hole.

14. The display apparatus of any preceding claim, wherein
the first area includes a first light emitting area,
the second area includes a second light emitting area, and
the first light emitting area and the second light emitting area have different pixel structures.

15. The display apparatus of claim 14, further comprising:
a third area outside the first area,
wherein the third area includes a third light emitting area, and
wherein the first light emitting area and the third light emitting area have different pixel structures.
